# EUROPEAN PATENT APPLICATION

(11) **EP 4 117 402 A1**
(43) Date of publication of application: **11.01.2023**
(21) Application number: 21183753.9
(22) Date of filing: 05.07.2021
(51) Int. Cl.: H05K 7/20, F28D 15/02

(54) **TWO-PHASE COOLING DEVICE FOR COOLING AN ELECTRONIC COMPONENT AND METHOD FOR MANUFACTURING THE TWO-PHASE COOLING DEVICE**

(71) Applicant: ABB SCHWEIZ AG, 5400 Baden (CH)
(72) Inventor: Petrov, Andrey, 8048 Zürich (CH); Sologubenko, Oleksandr, 8906 Bonstetten (CH); Torresin, Daniele, 5400 Baden (CH); Agostini, Bruno, 8006 Zürich (CH)
(74) Representative: Qip Patentanwälte Dr. Kuehn & Partner mbB

(57) **Abstract**

A two-phase cooling device (20) for cooling an electronic component is provided. The two-phase cooling device (20) comprises: a housing (22) surrounding a cavity (24), which has a top region (28) and a bottom region (30), with the bottom region (30) having a lower part (48) and an upper part (46); and a cooling medium (32) within the cavity (24) for cooling the electronic component by a phase transition from a liquid state to a gaseous state, wherein, when the cooling medium (32) is solely in the liquid state, the bottom region (30) is completely filled with the cooling medium (32) and the top region (28) is free from the cooling medium (32); wherein at least the lower part (48) of the bottom region (30) of the housing (22) is formed such that, if the cooling medium (32) freezes, the last part of the cooling medium (32) to freeze is an upper surface (38) of the cooling medium (32).

## Description

### FIELD OF THE INVENTION

The invention relates to the field of two-phase cooling devices. In particular, the invention relates to a two-phase cooling device for cooling an electronic component and to a method for manufacturing the two-phase cooling device.

### BACKGROUND OF THE INVENTION

Advanced two-phase cooling devices, e.g. 3D-cooling devices, like 3D vapor chambers, and/or 2D-cooling devices, like 2D vapor chambers, heat pipes or thermosyphons, for power electronic applications are made from a material having a high thermal conductivity, e.g. from metal, e.g. copper, and rely on using a cooling medium, e.g. water, as a working fluid for its optimal thermal properties.

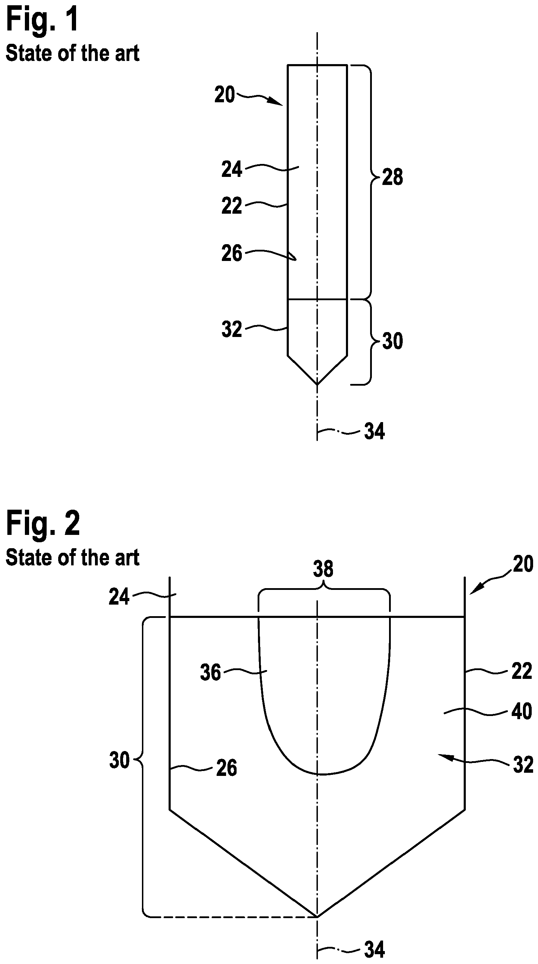

Fig. 1 shows an example of a two-phase cooling device 20, in particular a heat pipe or a 2D-vapor chamber according to the prior art. The cooling device 20 has a housing 22 enclosing a cavity 24, wherein an inner wall 26 of the housing 22 surrounds the cavity 24. The cavity 24 has a top region 28 and a bottom region 30. In figure 1, the cooling device 20 is oriented as it would be during normal usage of the cooling device 20. With this "normal" orientation, the top region 28 is arranged above the bottom region 30. A cooling medium 32 is in the cavity 24. When the cooling medium is solely in its liquid state and if there is a proper amount of cooling medium 32 within the cavity 24, the bottom region 30 is completely filled with the cooling medium 32, e.g. water, and the top region 29 is free from the cooling medium 32. In other words, if all of the cooling medium 32 is liquid, if exactly the right amount of liquid cooling medium 32 is within the cavity, the bottom region 30 is that region of the cavity 24, in which all of the cooling medium 32 is arranged. So, the height of the bottom region 30 is defined by the proper amount of liquid cooling medium 32 within the cavity 24. Further, most cooling devices 20 comprise a porous structure within the cavity 24. The porous structure covers at least a part of the inner wall 26 of the housing 22 and extends from the top region 28 to the bottom region 30. The porous structure is arranged for guiding condensed cooling medium 32 from the top region 28 to the bottom region 30.

The cooling device 20 is symmetric with respect to a symmetry axis 34. In case of the 2D-cooling device, the cooling device 20 is rotationally symmetric with respect to the symmetry axis 34. In case of the 3D-cooling device, the cooling device 20 may be mirror-symmetric, wherein the symmetry axis 34 may be representative for a corresponding symmetry plane.

In case of e.g. water as the cooling medium 32, when cooled below 0°C, the cooling medium 32 freezes. While undergoing this phase change, if there is more water inside the cavity 24 as may be contained within the porous structure, the water accumulates in the bottom region 30 because of gravity and may form a liquid water pocket, i.e. a completely enclosed amount of liquid cooling medium at some point.

Fig. 2 shows the bottom region 30, wherein the cooling medium 32 is present in the bottom region 30 as liquid cooling medium 36 and as frozen cooling medium 40. Because of the housing 22 having the high thermal conductivity, the cooling medium 32 freezes from the peripheral region of the bottom region 30 towards a center of the bottom region 30, wherein, in figures 1 and 2, the center of the bottom region of 30 corresponds to the symmetry axis 34 in the bottom region 30. So, if the cooling medium 32 freezes, firstly a pool of liquid cooling medium 36 is formed within the middle of the frozen cooling medium 40. The liquid cooling medium 36, in particular the pool, has an upper surface 38. As long as there is the upper surface 38 of liquid cooling medium 36, the expansion of the frozen cooling medium 40 pushes the remaining liquid cooling medium 36 towards the top region 28 and does not subject it to high pressure. So, even if there is the pool of water, the housing 22 would not bulge.

However, if the liquid cooling medium 36 begins to be surrounded by frozen cooling medium 40, in particular if the upper surface 38 of the liquid cooling medium 32 is closed, the pool of liquid cooling medium 36 is transformed into a pocket of enclosed liquid cooling medium 36 and high pressures on the inner walls 26 of the housing 22 appear, which ultimately cause a bulging of the housing 22 and/or a leakage of the cooling medium in the bottom region 30, and as a consequence a loss of cooling performance.

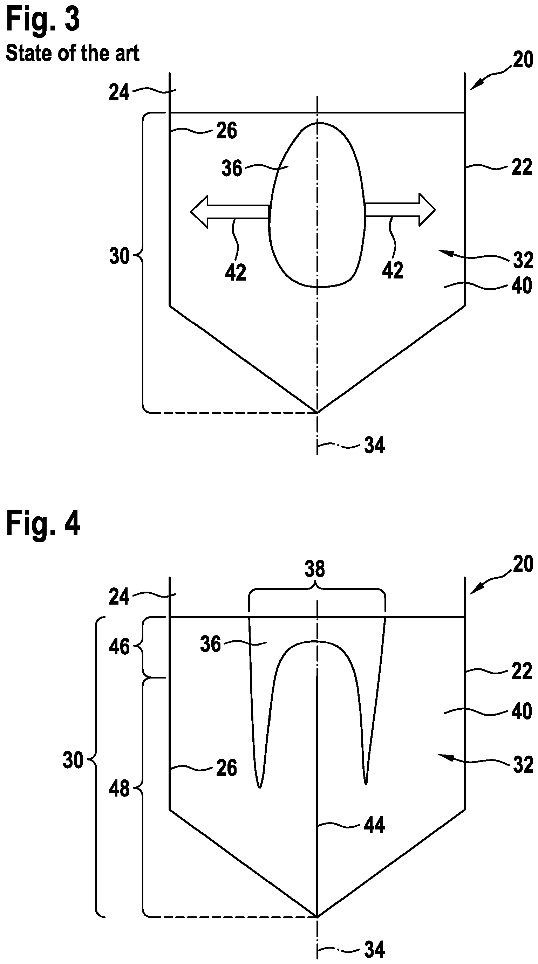

Fig. 3 shows the bottom region 30 of Fig. 2, wherein the cooling medium 32 is frozen such that the pocket of liquid cooling medium 36 is enclosed by the frozen cooling medium 40. The pressure acting on the housing 22 because of the expansion of the frozen cooling medium 40 and the presence of the pocket of liquid cooling medium 32 completely within the frozen cooling medium of 40 is represented by two arrows illustrating the direction 42 of the corresponding expansion force. The bulging of the housing 22 may in turn cause the leakage, through which the liquid cooling medium 36 may leak outside of the housing 22, and/or a loss of contact with the electronic component to be cooled, because of a deformed outer wall of the housing 22. Both cases will result in a failure of the cooling device 20 and/or the electronic component to be cooled.

Therefore, it is important to charge the correct amount of liquid cooling medium 36 inside the cavity 24. The correct amount of liquid cooling medium 36 is a tradeoff between the cooling performance and the reliability of the cooling device 20. The cooling performance increases with the amount of water, wherein the reliability of the cooling device 20 drops, if the amount of liquid cooling medium 36 is more than may be accommodated by the porous structure. The manufactures of the cooling devices 20 tend to fill a little bit more cooling medium 32 into the cavity 24, as needed in order to be on the safe side regarding the cooling performance of the cooling device 20. Therefore, it is important to have a free volume in the top region 30 for the cooling medium 32 to expand in case the manufacturer overfills the cooling device 20.

Following the above stated, the state-of-the-art design of the bottom region 30 of the two-phase cooling devices 20, i.e. the vapor chambers, thermosyphons or heat pipes, is not optimal and it presents a technical challenge for the reliability of two-phase cooling systems.

One solution would be to add additives (e.g. glycol) to the water preventing the freezing, but this would compromise the thermal performance of the cooling device 20.

### DESCRIPTION OF THE INVENTION

Therefore, it is an objective of the present invention to provide the two-phase cooling device for cooling an electronic component, with the two-phase cooling device having a high performance and a high reliability. In particular, it is an objective of the present invention to provide a two-phase cooling device for cooling an electronic component, with the two-phase cooling device being able two efficiently and reliable cool the electronic component. In particular, it is an objective of the present invention to provide a two-phase cooling device for cooling an electronic component, with the two-phase cooling device not being damaged by bulging of the housing of the cooling device, even if the cooling device is overfilled, and keeping its thermal contact to the electronic component to be cooled, in particular at temperatures below 0°C. It is another objective of the present invention to provide a method for manufacturing the above cooling device.

These objectives are achieved by the subject-matter of the independent claims. Further exemplary embodiments are evident from the dependent claims and the following description.

In particular, an objective of the present invention is achieved by a two-phase cooling device for cooling an electronic component. The two-phase cooling device comprises: a housing surrounding a cavity, which has a top region and a bottom region, with the bottom region having a lower part and an upper part; and a cooling medium within the cavity for cooling the electronic component by a phase transition from a liquid state to a gaseous state, wherein, when the cooling medium is solely in the liquid state, the bottom region is completely filled with the cooling medium and the top region is free from the cooling medium; wherein at least the lower part of the bottom region of the housing is formed such that, if the cooling medium freezes, the last part of the cooling medium to freeze is an upper surface of the cooling medium.

If the last part of the cooling medium to freeze is the upper surface of the cooling medium, the liquid cooling medium within the pool is pressed towards the top region, no pocket of enclosed liquid cooling medium is formed, and no pressure is put on the inner walls of the housing of the cooling device. Therefore, the two-phase cooling device is not damaged by bulging of the housing of the cooling device, even if the cooling device is overfilled, and the cooling device keeps its thermal contact to the electronic component to be cooled, in particular at temperatures below 0°C. Thus, the two-phase cooling device is able to efficiently and reliably cool the electronic component, with the two-phase cooling device providing a high performance and a high reliability. In short, the above cooling device provides an improved reliability by controlling the freezing dynamics of the cooling medium in the bottom region and prevents undesired bulging of the housing, which may cause loss of contact with the electronic component to be cooled or a cooling device failure or a failure of the electronic component by leakage.

The two-phase cooling device may be a 3D-cooling device, like a 3D vapor chamber, and/or a 2D-cooling device, like a 2D vapor chamber, heat pipe or thermosyphon. The electronic component may be a power electronic application, an electronic circuit, an integrated circuit, a chip, a transformer, etc. The housing may comprise or is made of a metal having a high thermal conductivity, e.g. copper. The lower part may be at least 10%, e.g. at least 50%, e.g. at least 60%, e.g. at least 70%, e.g. at least 80%, e.g. at least 90%, e.g. 100% of the bottom region. During normal usage of the two-phase cooling device, the top region is at the top of the cavity and the bottom region is at the bottom of the cavity, and the upper part of the bottom region is above the lower part of the bottom region. The cooling medium may for example be water.

According to an embodiment, the lower part of the of the bottom region is formed such that for every point inside the lower part a minimal distance to a wall of the housing is smaller than a minimal distance to the wall of the housing of central points inside the upper part. This causes that the last part of the cooling medium to freeze is the upper surface of the cooling medium, if the cooling medium is cooled under its freezing temperature. In other words, the purpose of these features is to affect the ice formation dynamics in such a way that the described above enclosed pocket of liquid cooling medium is not formed.

According to an embodiment, a horizontal cross-section of the housing in the lower part has a zigzag shape. At inwardly pointing edges of the zigzag shape an angled, in other words tilted, profile of the inner wall may extend to or beyond the upper part, the bottom region, and/or the level of the liquid cooling medium. The zigzag shape contributes to that the minimal distance of central points within the lower part of the bottom region is even smaller at edges of the zigzag shape pointing inwardly. Therefore, at these central points the freezing starts earlier contributing to that the last part of the cooling medium to freeze is the upper surface of the cooling medium. Further, the surface of the inner wall at the zigzag shape is slightly increased compared to a cross-section without the zigzag shape. This increased surface provides an additional surface for a crystallization of the freezing cooling medium, particularly in the area which is susceptible of the formation of the enclosed pocket, i.e. the lower part of the bottom region, thus preventing this phenomenon from occurring and as such contributing to that the last part of the cooling medium to freeze is the upper surface of the cooling medium.

According to an embodiment, the housing comprises at least one crystallization surface within the lower part, which increases an inner wall of the housing and which provides an additional surface for a crystallization of the cooling medium in the lower part, when the cooling medium freezes. The crystallization surface provides an additional surface for the crystallization of the freezing cooling medium, particularly in the area which is susceptible of the formation of the enclosed pocket, thus preventing this phenomenon from occurring and as such contributing to that the last part of the cooling medium to freeze is the upper surface of the cooling medium.

According to an embodiment, the crystallization surface is formed by at least one ledge extending at least in part from a central portion of the lower part towards a central portion of the upper part. The ledge may be a protrusion in the middle of the lower part of the bottom region extending vertically from a bottom edge of the housing if the cooling device is normally oriented. The ledge enables in a very easy way to provide the crystallization surface. Optionally, there are two or more corresponding ledges arranged within the lower part of the bottom region, e.g. if the cooling device is a vapor chamber.

According to an embodiment, the crystallization surface is formed by at least one ledge extending from an outer wall of the housing in the lower part towards a central portion of the lower part. The ledge may be a protrusion of the housing extending horizontally from a side of the cavity towards the centre of the lower part if the cooling device is normally oriented. The ledge enables in a very easy way to provide the crystallization surface. Optionally, there are two or more corresponding ledges arranged within the lower part of the bottom region, e.g. if the cooling device is a vapor chamber. For example, two or more ledges are arranged at the sides of the cavity in the lower part of the bottom region, e.g. arranged at periodic intervals and/or with the same distance from each other.

According to an embodiment, the two-phase cooling device further comprises: a porous structure covering at least a part of the inner wall of the housing and extending from the top region to the bottom region for guiding condensed cooling medium from the top region to the bottom region.

The above features, advantages and/or effects of the two-phase cooling device for cooling an electronic component may be transferred to the method for cooling an electronic component as explained in the following. Therefore, a repetition of these features, advantages and/or effects is omitted and it is referred to the above explanations only in order to provide a concise description.

An objective of the present invention is achieved by a method for manufacturing a two-phase cooling device for cooling an electronic component, the method comprising: forming the housing surrounding the cavity, which has the top region and the bottom region, with the bottom region having the lower part and the upper part; and filling the cooling medium in the cavity for cooling the electronic component by a phase transition from a liquid state to a gaseous state, such that, when the cooling medium is solely in the liquid state, the bottom region is completely filled with the cooling medium and the top region is free from the cooling medium; wherein at least the lower part of the bottom region of the housing is formed such that, if the cooling medium freezes, the last part of the cooling medium to freeze is the upper surface of the cooling medium.

According to an embodiment, the lower part of the of the bottom region is formed such that for every point inside the lower part the minimal distance to the inner wall of the housing is smaller than the minimal distance to the inner wall of the housing of central points inside the upper part.

According to an embodiment, the housing is formed such that the horizontal cross-section of the housing in the lower part has the zigzag shape.

According to an embodiment, the housing is formed such that it comprises the at least one crystallization surface within the lower part, which increases the inner wall of the housing and which provides an additional surface for a crystallization of the cooling medium in the lower part, when the cooling medium freezes.

According to an embodiment, the crystallization surface is formed by forming at least one ledge extending at least in part from the central portion of the lower part towards the central portion of the upper part.

According to an embodiment, the crystallization surface is formed by forming at least one ledge extending from the outer wall of the housing in the lower part towards the central portion of the lower part.

According to an embodiment, the method further comprises forming the porous structure covering at least in part the inner wall of the housing and extending from the top region to the bottom region for guiding condensed cooling medium from the top region to the bottom region.

These and other aspects of the invention will be apparent from and elucidated with reference to the embodiments described hereinafter.

### BRIEF DESCRIPTION OF THE DRAWINGS

The subject matter of the invention will be explained in more detail in the following text with reference to exemplary embodiments which are illustrated in the attached drawings.
Fig. 1 schematically shows a two-phase cooling device according to the prior art;
Fig. 2 schematically shows a detailed view of a two-phase cooling device according to the prior art in a first state;
Fig. 3 schematically shows the two-phase cooling device according to figure 2 in a second state;
Fig. 4 schematically shows a detailed view of an exemplary embodiment of a two-phase cooling device according to the present invention;
Fig. 5 schematically shows a detailed view of an exemplary embodiment of a two-phase cooling device according to the present invention;
Fig. 6 schematically shows a detailed view of an exemplary embodiment of a two-phase cooling device according to the present invention;
Fig. 7 schematically shows an exemplary embodiment of a two-phase cooling device according to the present invention;
Fig. 8 schematically illustrates a first step of an exemplary embodiment of a method for manufacturing a two-phase cooling device, according to the present invention;
Fig. 9 schematically illustrates a second step of the method for manufacturing of a two-phase cooling device, according to figure 8;
Fig. 10 schematically illustrates a first step of an exemplary embodiment of a method for manufacturing a two-phase cooling device, according to the present invention;
Fig. 11 schematically illustrates a second step of the method for manufacturing a two-phase cooling device, according to figure 10;
Fig. 12 schematically illustrates a third step of the method for manufacturing a two-phase cooling device, according to figure 10;
Fig. 13 shows a flow chart of an exemplary embodiment of a method for manufacturing a two-phase cooling device, according to the present invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

Fig. 1 schematically shows a two-phase cooling device 20 according to the prior art. The cooling device 20 may be a 3D-cooling device, e.g. a 3D vapor chamber, or a 2D-cooling device, e.g. a 2D vapor chamber, heat pipe or a thermosyphon The cooling device 20 may be used for cooling and electronic component (not shown). The electronic component may be an electronic circuit, an integrated circuit, a chip, a transformer, etc.

The cooling device 20 comprises a housing 22. The housing 22 may comprise or may be made of a material having a high thermal conductivity, e.g. a metal, e.g. copper. The housing 22 encloses a cavity 24. The cavity 24 is surrounded by an inner wall 26 of the housing 24. In figure 1, the cooling device 20 is orientated as it would be during normal usage, i.e. when cooling the electronic component. With this "normal" orientation, a top region 28 of the cooling device 20 is above a bottom region 30 of the cooling device 20. A cooling medium 32, e.g. water, is arranged within the cavity 24. Further, the cooling device 20 may comprise a porous structure (not shown), which may be arranged at the inner wall 26 and/or which may be arranged all over the cavity 24. The cooling device 20 is symmetric with respect to a symmetry axis 34. In case of the 2D-cooling device, the cooling device 20 may be rotationally symmetric with respect to the symmetry axis 34. In case of the 3D-cooling device, the cooling device 20 may be mirror-symmetric, wherein the symmetry axis 34 may be representative for a corresponding symmetry plane.

Prior to the use of the cooling device 20, the cooling medium 32 is in a liquid state. During normal usage of the cooling device 20, the cooling device 20 has thermal contact to the electronic component to be cooled at least in the bottom region 30 and absorbs at least in part the thermal energy generated by the operation of the electronic component. If the cooling device 20 absorbs sufficient thermal energy from the electronic component, the cooling medium 32 transitions at least in part from the liquid state to a gaseous state. The cooling medium 32 in the gaseous state rises to the top region 28 and condenses in the top region 28. The condensed cooling medium 32 is guided by the porous structure from the top region 28 to the bottom region 30. If all of the cooling medium 32 is in the liquid state, a part of the cooling medium 32 is absorbed within the porous structure and the rest of the cooling medium 32 is within the bottom region 30, wherein an upper border of the bottom region 30 is defined by an upper surface of the liquid cooling medium 32. If the cooling device 20 is cooled below 0°C, at least a part of the cooling medium 32 freezes.

Fig. 2 schematically shows a detailed view of a two-phase cooling device 20 according to the prior art in a first state, e.g. the two-phase cooling device 20 according to figure 1. In the first state, are part of the cooling medium 32 is frozen and the rest of the cooling medium 32 is still liquid. In particular, a pool of liquid cooling medium 36 having an upper surface 38 is partly embedded within frozen cooling medium 40. If the freezing process proceeds, the liquid cooling medium 36 may be pressed upwards by an expansion of the frozen cooling medium 40 as long as the upper surface 38 of the pool is open and as such exists. However, because of the higher thermal conductivity of the material of the housing 22, the upper surface 38 of the pool may be closed by the frozen cooling medium 40 and as such may disappear.

Fig. 3 schematically shows the two-phase cooling device 20 according to figure 2 in a second state. In the second state, a pocket of a liquid cooling medium 36 is formed. The pocket of liquid cooling medium 36 is completely enclosed by the frozen cooling medium 40. If the freezing process proceeds further, the frozen cooling medium 40 increases and expands further, but the liquid cooling medium 36 cannot be pressed upwards, because the pocket is closed. Then, an expansion force is created, which acts on the inner wall 26 of the housing 22 in a direction 42. This expansion force may lead to a bulging of the housing 22 and may, if the bulging proceeds, lead to a leakage in the housing 22.

The inventors of the present invention have recognized that the formation of the pocket of liquid cooling medium 36 and the associated bulging of the housing and in case the leakage of the housing 22 may be avoided, if the bottom region 30 is formed such that, if the cooling medium 32 freezes, the last part of the cooling medium 32 to freeze is the upper surface 38 of the liquid cooling medium 36. The technical effect of this inventive idea is that at any time during the freezing process the rest of liquid cooling medium 36 may be pressed upwards by the freezing cooling medium 32.

Fig. 4 schematically shows a detailed view of an exemplary embodiment of a two-phase cooling device 20 according to the present invention. The two-phase cooling device 20 according to the present invention may widely correspond to the above cooling device 20. Therefore, in order to avoid unnecessary repetitions and to provide a concise description, only the those features of the cooling device 20 are explained in the following which differentiate the cooling device 20 according to the present invention from the cooling device 20 according to the prior art.

The bottom region 30 of the cooling device 20 has an upper part 46 and the lower part 48. The lower part 48 may be at least 10%, e.g. at least 50%, e.g. at least 60%, e.g. at least 70%, e.g. at least 80%, e.g. at least 90%, e.g. 100% of the bottom region 30. If the cooling device 20 is oriented normally, the upper part 46 is above the lower part 48. The lower part 48 is formed such that, if the cooling medium 32 freezes, the last part of the cooling medium 32 to freeze is the upper surface 38 of the liquid cooling medium 36. In other words, the lower part 48 is formed such that, if the cooling medium 32 freezes, the cooling medium 32 freezes bottom up. In particular, the lower part 48 of the of the bottom region 30 is formed such that for every point inside the lower part 48 a minimal distance to the inner wall 26 of the housing 22 is smaller than a minimal distance to the inner wall 26 of the housing 22 of central points inside the upper part 46. The central points may be found on the symmetry axis 34. For example, the housing 22 comprises at least one crystallization surface within the lower part 48, which increases the inner wall 26 of the housing 22 and which provides an additional surface for a crystallization of the cooling medium 32 in the lower part 48, when the cooling medium 32 freezes. The crystallization surface provides an additional surface for the crystallization of the freezing cooling medium 32, particularly in the area which is susceptible of the formation of the above enclosed pocket of liquid cooling medium 36.

The crystallization surface may be formed by at least one ledge 44 extending at least in part from a central portion of the lower part 48 towards a central portion of the upper part 46. The ledge 44 may be a protrusion in the middle of the lower part 48 of the bottom region 30 extending vertically from a bottom edge of the housing 22. The ledge 44 may for example be rod-shaped or plate-shaped. Optionally, there are two or more corresponding ledges 44 arranged within the lower part 48 of the bottom region 30, e.g. if the cooling device 20 is a 3D-cooling device. During the manufacturing of the cooling device 20 the ledge 44 may be attached to the housing 22 and then may be regarded as a part of the housing 22.

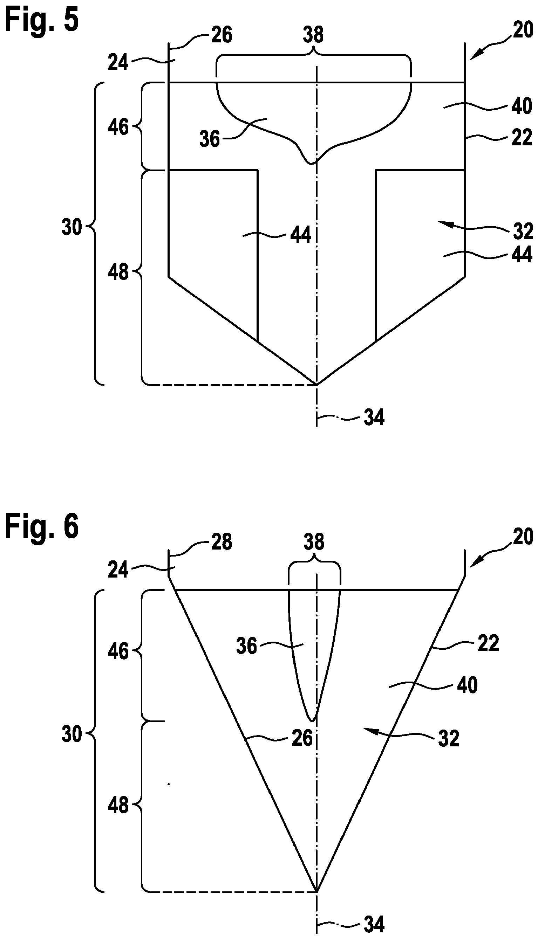

Fig. 5 schematically shows a detailed view of an exemplary embodiment of a two-phase cooling device 20 according to the present invention. The two-phase cooling device 20 according to figure 5 may widely correspond to the above cooling device 20 according to figure 4. Therefore, in order to avoid unnecessary repetitions and to provide a concise description, only the those features of the cooling device 20 are explained in the following which differentiate the cooling device 20 according to figure 5 from the cooling device 20 according to figure 4.

The lower part 48 is formed such that, if the cooling medium 32 freezes, the last part of the cooling medium 32 to freeze is the upper surface 38 of the liquid cooling medium 36. In particular, the lower part 48 of the of the bottom region 30 may be formed such that for every point inside the lower part 48 a minimal distance to the inner wall 26 of the housing 22 is smaller than a minimal distance to the inner wall 26 of the housing 22 of central points inside the upper part 46. For example, the housing 22 comprises at least one crystallization surface within the lower part 48, which increases the inner wall 26 of the housing 22 and which provides an additional surface for a crystallization of the cooling medium 32 in the lower part 48, when the cooling medium 32 freezes. The crystallization surface provides an additional surface for the crystallization of the freezing cooling medium 32, particularly in the area which is susceptible of the formation of the above enclosed pocket of liquid cooling medium 36.

The crystallization surface may be formed by at least one ledge 44 extending from a peripheral region of the lower part 48 towards a central portion of the lower part 48. The ledge 44 may be a protrusion of the housing 22 extending horizontally from a side of the cavity 24 towards the centre of the lower part 48. During the manufacturing of the cooling device 20 the ledge 44 may be attached to the housing 22 and then may be regarded as a part of the housing 22. Optionally, there are two or more corresponding ledges 44 arranged within the lower part 48 of the bottom region 30, e.g. if the cooling device 20 is a 3D-cooling device. For example, two or more ledges 44 are arranged at the sides of the cavity 24 within the lower part 48 of the bottom region 30, e.g. arranged at periodic intervals and/or with the same distance from each other.

Fig. 6 schematically shows a detailed view of an exemplary embodiment of a two-phase cooling device 20 according to the present invention. The two-phase cooling device 20 according to figure 6 may widely correspond to the above cooling device 20 according to figure 5. Therefore, in order to avoid unnecessary repetitions and to provide a concise description, only the those features of the cooling device 20 are explained in the following which differentiate the cooling device 20 according to figure 6 from the cooling device 20 according to figure 5.

The lower part 48 is formed such that, if the cooling medium 32 freezes, the last part of the cooling medium 32 to freeze is the upper surface 38 of the cooling medium 32. In particular, the lower part 48 of the of the bottom region 30 may be formed such that for every point inside the lower part 48 a minimal distance to the inner wall 26 of the housing 22 is smaller than a minimal distance to the inner wall 26 of the housing 22 of central points inside the upper part 46.

The housing 22 is formed in the lower part 48 such that the inner wall 26 is tilted, in other words angled, with respect to the vertical inner wall 26 in the top region 28. For example, the inner wall 26 is correspondingly tilted in the upper part 46 also. So, the inner wall 26 may be correspondingly tilted within the whole bottom region 30. If the cooling device 20 is the 3D-cooling device, the cooling device 20 may have different vertical cross-sections depending on the position of the corresponding cross-section along the longitudinal dimension of the cooling device 20. For example, a first vertical cross-section at a first longitudinal position of the cooling device 20 may correspond to the cross-section of the prior art cooling device 20 according to figure 2 and a second vertical cross-section at a second longitudinal position of the cooling device 20 may correspond to the cross-section of the cooling device 20 according to figure 6. In the result, a horizontal cross-section of the housing 22 in the lower part 48 may have a zigzag shape.

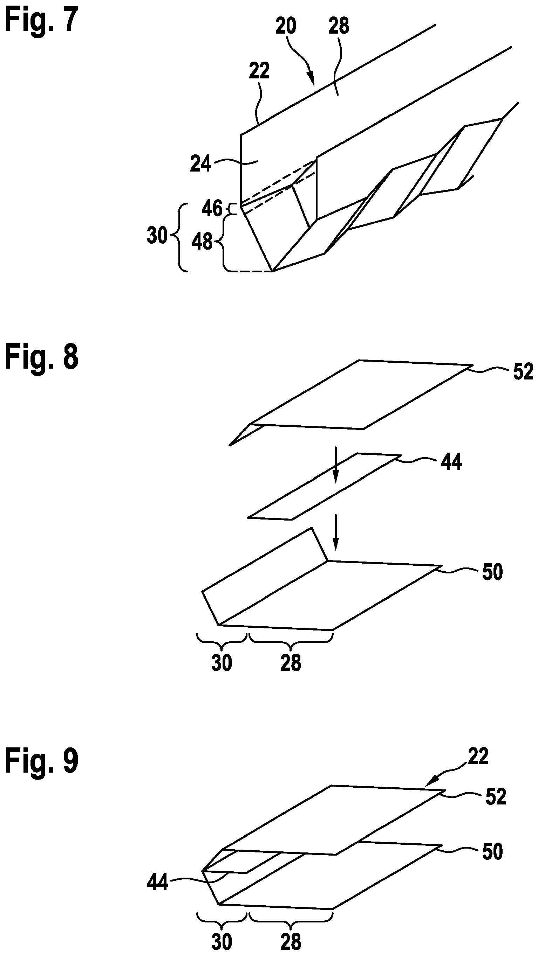

Fig. 7 schematically shows an exemplary embodiment of a two-phase cooling device 20 according to the present invention. In particular, the 3D-cooling device shown in figure 7 may correspond to the 3D-version of the cooling device 20 shown in figure 6 and may have the different vertical cross-sections along the longitudinal extension of the cooling device 20 such that the horizontal cross-section of the housing 22 in the lower part 48 has the zigzag shape. At inwardly pointing edges of the zigzag shape the angled, in other words tilted, profile of the inner wall 26 in the lower part 48 may extend to or beyond the upper part 46, an upper boundary of the bottom region 30, and/or the level of the liquid cooling medium 36. The surface of the inner wall 26 at the zigzag shape is slightly increased compared to a cross-section without the zigzag shape. This increased surface provides an additional surface for the crystallization of the freezing cooling medium 32, particularly in the area which is susceptible of the formation of the enclosed pocket, i.e. the lower part 48 of the bottom region 30.

For ease of explanation, sidewalls for closing the cavity 24 in the longitudinal direction and a cover for closing the cavity 24 in the vertical direction are not shown in the figures.

Fig. 8 schematically illustrates a first step of an exemplary embodiment of a method for manufacturing a two-phase cooling device, according to the present invention, e.g. 3D-version of the cooling device 20 explained with respect to figure 4. During the first step, a first side 50 of the housing 22 is arranged in a mounting area and a second side 52 of the housing 22 is arranged on the first side 50. The plate-shaped ledge 44 may be sandwiched between the upper part 52 and the lower part 50. The correspondingly arranged ledge 44 extends from a central portion of the lower part 48 towards a central portion of the upper part 46. The ledge 44 forms an additional crystallization surface.

Fig. 9 schematically illustrates a second step of the method for manufacturing a two-phase cooling device, according to figure 8. During the second step, the first and second side 50, 52 may be fixed to each other and the ledge 44 may be fixed to both sides 50, 52, e.g. by welding.

For ease of explanation, sidewalls for closing the cavity 24 in the longitudinal direction and a cover for closing the cavity 24 in the vertical direction are not shown in the figures.

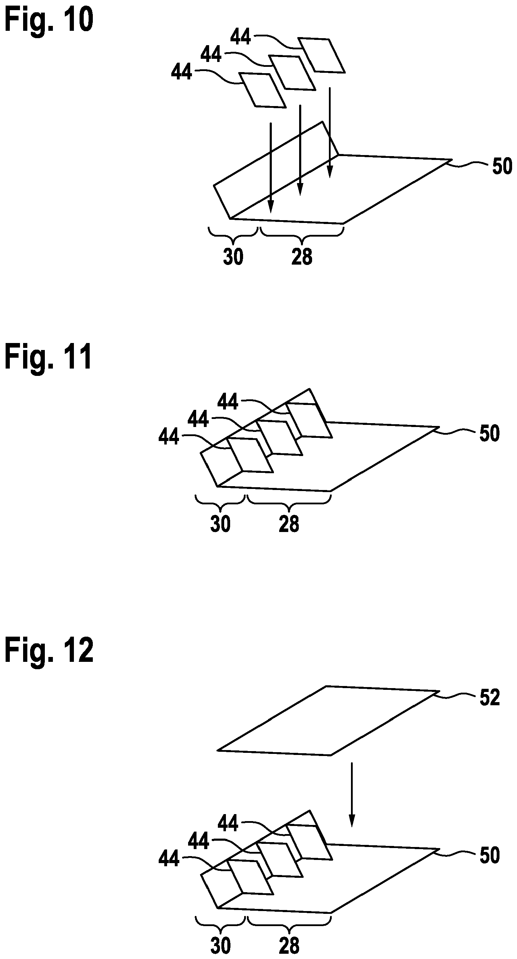

Fig. 10 schematically illustrates a first step of an exemplary embodiment of a method for manufacturing a two-phase cooling device, according to the present invention. During the first step, the first side 50 of the housing 22 may be arranged in the mounting area and several plate-shaped ledges 44, e.g. three plate-shaped ledges 44 may be arranged on the first side 50.

Fig. 11 schematically illustrates a second step of the method for manufacturing a two-phase cooling device, according to figure 10. During the second step, the plate-shaped ledges 44 may be fixed to the first side 50, e.g. by welding.

Fig. 12 schematically illustrates a third step of the method for manufacturing a two-phase cooling device, according to figure 10. During the third step, the second side 52 is arranged on the first side 50 such that the plate-shaped ledges 44 are sandwiched between the first side 50 and the second side 52. The ledges 44 extend from the peripheral region of the cavity 24 in the lower part 48 towards the central portion of the cavity 24 in the lower part 48. The additional crystallization surface is formed by the ledges 44.

For ease of explanation, sidewalls for closing the cavity 24 in the longitudinal direction and a cover for closing the cavity 24 in the vertical direction are not shown in the figures.

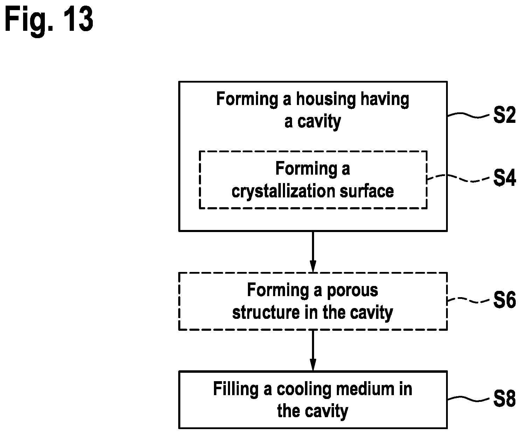

Fig. 13 shows a flow chart of an exemplary embodiment of a method for manufacturing of a two-phase cooling device, according to the present invention, e.g. one of the cooling devices 20 as explained above.

In step S2, a housing having a cavity is formed, e.g. the housing 22 having the cavity 24. The housing 22 is formed such that if the cooling medium 32 freezes, the last part of the cooling medium 32 to freeze is the upper surface 38 of the cooling medium 32. In particular, the lower part 48 of the of the bottom region 30 may be formed such that for every point inside the lower part 48 the minimal distance to the inner wall 26 of the housing 22 is smaller than the minimal distance to the inner wall 26 of the housing 22 of central points inside the upper part 46. For example, the housing 22 is formed such that the horizontal cross-section of the housing 22 in the lower part 48 has the zigzag shape, as explained with respect to figures 6 and 7. Alternatively or additionally, a step S4 may be carried out.

In step S4, the crystallization surface may be formed, e.g. by forming one or more of the above ledges 44. For example, the crystallization surface may be formed by one or more ledges 44 each extending at least in part from the central portion of the lower part 48 towards the central portion of the upper part 46, as explained with respect to figures 4, 8, and 9. Alternatively or additionally, the crystallization surface may be formed by one or more ledges 44 extending from the peripheral region of the cavity 24 in the lower part 48 towards the central portion of the cavity 24 in the lower part 48, as explained with respect to figures 5 and 10 to 12.

In an optional step S6, the porous structure may be formed in the cavity 24.

In step S8, the cooling medium is filled into the cavity, e.g. the cooling medium 32 is filled into the cavity 24.

The above ledges 44, in other words protrusions, may be made from the same material as the corresponding housing 22. The ledges 44 may be made of a sheet metal, fibres, or sintered powder, or may be manufactured simultaneously together with the inner walls 26 of the housing 22 in a single process, e.g. by additive manufacturing. In a multi-step process, e.g. as explained above, the ledges 44 may be introduced during soldering or a diffusion bonding process, when various parts (not shown) of the cooling device 20, like pillars, powder top and/or bottom plates, are arranged at each other and heated to a melting point of the corresponding solder or to a diffusion bonding temperature of the corresponding material. In one variant the ledges 44 may be placed between the first and second sides 50, 52 of the corresponding cooling device 20, e.g. as explained with respect to figures 10 to 12. In another variant, the ledges 44 may be diffusion bonded to the top and bottom plates in a separate step prior to the final sealing of the cooling device 20, e.g. as explained with respect to figures 8 and 9. In another variant, the first and second sides 50, 52 may be stamped to produce the zigzag shape, which would act as a periodic side ledge 44 and/or corresponding additional crystallization surface, e.g. as explained with respect to figures 6 and 7.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 20: cooling device
- 22: housing
- 24: cavity
- 26: inner wall of housing
- 28: top region
- 30: bottom region
- 32: cooling medium
- 34: symmetry axis
- 36: liquid cooling medium
- 38: upper surface of liquid cooling medium
- 40: frozen cooling medium
- 42: direction of expansion force
- 44: ledge
- 46: upper part
- 48: lower part
- 50: first side
- 52: second side

## Claims

1. A two-phase cooling device (20) for cooling an electronic component, the two-phase cooling device (20) comprising:
a housing (22) surrounding a cavity (24), which has a top region (28) and a bottom region (30), with the bottom region (30) having a lower part (48) and an upper part (46); and
a cooling medium (32) within the cavity (24) for cooling the electronic component by a phase transition from a liquid state to a gaseous state, wherein, when the cooling medium (32) is solely in the liquid state, the bottom region (30) is completely filled with the cooling medium (32) and the top region (28) is free from the cooling medium (32); wherein at least the lower part (48) of the bottom region (30) of the housing (22) is formed such that, if the cooling medium (32) freezes, the last part of the cooling medium (32) to freeze is an upper surface (38) of the cooling medium (32).

2. Two-phase cooling device (20) in accordance with claim 1, wherein
the lower part (48) of the of the bottom region (30) is formed such that for every point inside the lower part (48) a minimal distance to an inner wall (26) of the housing (22) is smaller than a minimal distance to the inner wall (26) of the housing (22) of central points inside the upper part (46).

3. Two-phase cooling device (20) in accordance with one of the preceding claims, wherein
a horizontal cross-section of the housing (22) in the lower part (48) has a zigzag shape.

4. The two-phase cooling device (20) in accordance with claim 1, wherein
the housing (22) comprises at least one crystallization surface within the lower part (48), which increases a surface of an inner wall (26) of the housing (22) and which provides an additional surface for a crystallization of the cooling medium (32) in the lower part (48), when the cooling medium (32) freezes.

5. The two-phase cooling device (20) in accordance with claim 4, wherein
the crystallization surface is formed by at least one ledge (44) extending at least in part from a central portion of the lower part (48) towards a central portion of the upper part (46).

6. Two-phase cooling device (20) in accordance with claim 4, wherein
the crystallization surface is formed by at least one ledge (44) extending from a peripheral region of the cavity (24) in the lower part (48) towards a central portion of the cavity (24) in the lower part (48).

7. Two-phase cooling device (20) in accordance with one of the preceding claims, further comprising:
a porous structure covering at least a part of the inner wall (26) of the housing (22) and extending from the top region (28) to the bottom region (30) for guiding condensed cooling medium (32) from the top region (28) to the bottom region (30).

8. A method for manufacturing a two-phase cooling device (20) for cooling an electronic component, the method comprising:
forming a housing (22) surrounding a cavity (24), which has a top region (28) and a bottom region (30), with the bottom region (30) having a lower part (48) and an upper part (46); and
filling a cooling medium (32) in the cavity (24) for cooling the electronic component by a phase transition from a liquid state to a gaseous state, such that, when the cooling medium (32) is solely in the liquid state, the bottom region (30) is completely filled with the cooling medium (32) and the top region (28) is free from the cooling medium (32); wherein at least the lower part (48) of the bottom region (30) of the housing (22) is formed such that, if the cooling medium (32) freezes, the last part of the cooling medium (32) to freeze is an upper surface (38) of the cooling medium (32).

9. Method in accordance with claim 8, wherein
the lower part (48) of the of the bottom region (30) is formed such that for every point inside the lower part (48) a minimal distance to an inner wall (26) of the housing (22) is smaller than a minimal distance to the inner wall (26) of the housing (22) of central points inside the upper part (46).

10. Method in accordance with one of claims 8 or 9, wherein
the housing (22) is formed such that a horizontal cross-section of the housing (22) in the lower part (48) has a zigzag shape.

11. Method in accordance with claim 8, wherein
the housing (22) is formed such that it comprises at least one crystallization surface within the lower part (48), which increases a surface of an inner wall (26) of the housing (22) and which provides an additional surface for a crystallization of the cooling medium (32) in the lower part (48), when the cooling medium (32) freezes.

12. Method in accordance with claim 11, wherein
the crystallization surface is formed by forming at least one ledge (44) extending at least in part from a central portion of the lower part (48) towards a central portion of the upper part (46).

13. Method in accordance with claim 11, wherein
the crystallization surface is formed by forming at least one ledge (44) extending from a peripheral region of the cavity (24) in the lower part (48) towards a central portion of the cavity (24) in the lower part (48).

14. Method in accordance with one of claims 8 to 13, further comprising:
forming a porous structure covering at least a part of the inner wall (26) of the housing (22) and extending from the top region (28) to the bottom region (30) for guiding condensed cooling medium (32) from the top region (28) to the bottom region (30).
